(19) **Europäisches Patentamt / European Patent Office / Office européen des brevets**

(11) **EP 4 189 748 B1**

(12) **FASCICULE DE BREVET EUROPEEN**

(45) Date de publication et mention
de la délivrance du brevet:
**20.05.2026 Bulletin 2026/21**

(21) Numéro de dépôt: **21749173.7**

(22) Date de dépôt: **23.07.2021**

(51) Classification Internationale des Brevets (IPC):
***H10F 10/166*** (2025.01) ***H10F 71/10*** (2025.01)

(52) Classification Coopérative des Brevets (CPC):
**H10F 71/10; H10F 10/166; Y02E 10/50; Y02P 70/50**

(86) Numéro de dépôt international:
**PCT/EP2021/070748**

(87) Numéro de publication internationale:
**WO 2022/023221 (03.02.2022 Gazette 2022/05)**

(54) **PROCÉDÉ DE TRAITEMENT D'UN PRÉCURSEUR DE CELLULE PHOTOVOLTAÏQUE À HÉTÉROJONCTION**

**VERFAHREN ZUR VERARBEITUNG EINES VORLÄUFERS EINER HETEROÜBERGANGS-PHOTOVOLTAIKZELLE**

**METHOD FOR PROCESSING A PRECURSOR OF A HETEROJUNCTION PHOTOVOLTAIC CELL**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats de validation désignés:
**MA**

(30) Priorité: **29.07.2020 FR 2008017**

(43) Date de publication de la demande:
**07.06.2023 Bulletin 2023/23**

(73) Titulaire: **Commissariat à l'Energie Atomique et aux Energies Alternatives**
**75015 Paris (FR)**

(72) Inventeurs:
- **KINFACK LEOGA, Arnaud**
**38054 GRENOBLE CEDEX 09 (FR)**
- **VEIRMAN, Jordi**
**38054 GRENOBLE CEDEX 09 (FR)**

(74) Mandataire: **Cabinet Camus Lebkiri**
**25 rue de Maubeuge**
**75009 Paris (FR)**

(56) Documents cités:
EP-A1- 2 963 692    EP-A1- 3 182 465
EP-A2- 1 734 589    WO-A1-2013/001440
CN-A- 110 518 095

- EIJI KOBAYASHI ET AL: "Increasing the efficiency of silicon heterojunction solar cells and modules by light soaking", SOLAR ENERGY MATERIALS AND SOLAR CELLS,, vol. 173, 1 January 2017 (2017-01-01), pages 43 - 49, XP002802653, DOI: 10.1 0L 6/J.SOLMAT.2017 .06.023

**Description**

**DOMAINE TECHNIQUE DE L'INVENTION**

La présente invention concerne un procédé de traitement d'un empilement obtenu lors de la fabrication d'une cellule photovoltaïque à hétérojonction, afin d'améliorer et stabiliser le rendement de la cellule photovoltaïque.

**ARRIÈRE-PLAN TECHNOLOGIQUE DE L'INVENTION**

Une cellule photovoltaïque à hétérojonction est un dispositif capable d'absorber le rayonnement solaire et de le convertir en énergie électrique. Un tel dispositif comprend une jonction p-n formée par la superposition de deux matériaux semi-conducteurs ayant des largeurs de bande interdite différentes, tels que le silicium cristallin et le silicium amorphe.

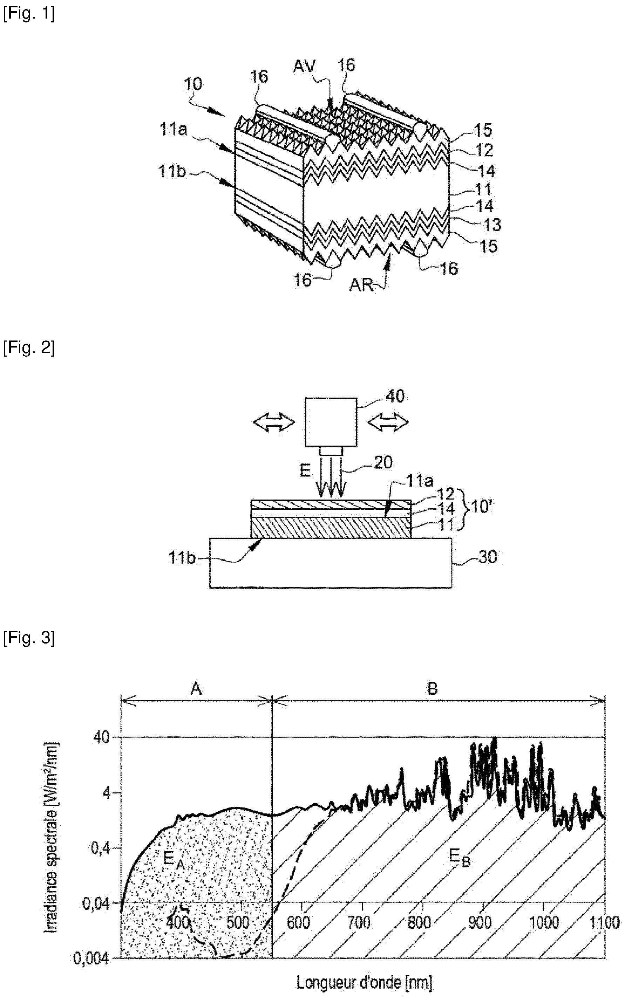

La figure 1 représente un exemple de cellule photovoltaïque 10 à hétérojonction de silicium (SHJ). La cellule photovoltaïque 10 comprend un substrat 11 en silicium cristallin dopé et deux couches de silicium amorphe dopé 12, 13 disposées de part et d'autre du substrat 11. L'une des couches de silicium amorphe dopé 12, 13 est dopée du même type de conductivité que le substrat 11, par exemple de type n, et l'autre couche est dopée du type de conductivité opposé, c'est-à-dire de type p.

L'hétérojonction est formée par le substrat 11 en silicium cristallin dopé n et la couche de silicium amorphe dopée p, cette couche formant l'émetteur de la cellule photovoltaïque. L'émetteur peut être situé en face avant AV ou en face arrière AR de la cellule photovoltaïque.

La cellule photovoltaïque SHJ est particulièrement sensible aux défauts situés à l'interface entre le substrat 11 en silicium cristallin et les couches de silicium amorphe dopé 12, 13. Ces défauts peuvent être des liaisons pendantes, également appelées « dangling bonds » en anglais, ou des impuretés telles que des ions métalliques. Ils introduisent des niveaux d'énergie dans la bande interdite du silicium et augmentent le nombre de recombinaisons électron-trou aux interfaces, ce qui détériore les paramètres de sortie de la cellule photovoltaïque, tels que la tension en circuit ouvert Voc.

Pour obtenir une cellule photovoltaïque performante, il est donc nécessaire de minimiser le nombre de recombinaisons en surface du substrat 11, ce qui est généralement accompli en déposant une couche de passivation 14 en silicium amorphe hydrogéné intrinsèque sur chacune des faces du substrat 11, avant la couche de silicium amorphe dopé 12,13. Les atomes d'hydrogène contenus dans les couches de passivation 14 diffusent jusqu'à la surface du substrat 11 et neutralisent les défauts.

Chacune des couches de silicium amorphe dopé 12, 13 est par ailleurs recouverte d'une couche d'oxyde transparent conducteur 15 (ou TCO, pour « Transparent Conductive Oxyde » en anglais).

Les cellules photovoltaïques SHJ sont connues pour voir leur rendement de conversion énergétique s'améliorer d'environ 0,3 % absolu sous l'action conjuguée de l'éclairement et de la température. Ce phénomène de « bonification » des cellules résulte de l'amélioration d'une des couches de passivation 14 en silicium amorphe hydrogéné et d'une des couches de silicium amorphe dopé de type p ainsi que de l'amélioration des interfaces entre la couche de silicium amorphe dopé de type p et l'une des couches de TCO 15.

Le document WO2013/001440 décrit un exemple de procédé de traitement de cellule photovoltaïque SHJ comprenant un substrat en silicium cristallin dopé n. Dans ce procédé de traitement, la cellule photovoltaïque est soumise à un flux lumineux d'irradiance supérieure ou égal à 500 W/m² pendant une durée d'environ 10 heures, tout en étant chauffée à une température comprise entre 20 °C et 200 °C. Une telle durée de traitement est incompatible avec la cadence des lignes de production actuelles de cellules photovoltaïques.

Le document [Increasing the efficiency of silicon heterojunction solar cells and modules by light soaking, E. Kobayashi & al., Solar Energy Materials and Solar Cells, Vol. 173, Pages 43-49, 2017] divulgue également un procédé de traitement permettant d'augmenter le rendement de conversion d'une cellule photovoltaïque SHJ comprenant un substrat en silicium cristallin dopé n. Le procédé comprend une exposition de la face comprenant une couche de silicium amorphe dopée p, dite couche émetteur, à un rayonnement électromagnétique standard AM1.5G (rayonnement solaire au niveau de la mer). Toutefois, la durée d'exposition permettant de noter un effet sur le rendement de conversion est d'environ 14 heures. Les documents EP 1734589 A2 et EP 3182465 A1 décrivent des procédés de traitement d'un empilement de couches semiconductrices comprenant une étape d'exposition de l'empilement à une source de lumière, tel que connu dans l'état de l'art.

**RÉSUMÉ DE L'INVENTION**

l'objet de la présente invention est défini dans les revendications indépendantes 1, 13 et 14. Il existe donc un besoin de prévoir un procédé de traitement d'un empilement obtenu lors de la fabrication d'une cellule photovoltaïque à hétérojonction permettant d'augmenter la cinétique de bonification du rendement de conversion de la cellule photo-voltaïque.

**EP 4 189 748 B1**

Un aspect de l'invention concerne un procédé de traitement d'un empilement, l'empilement comprenant :

- un substrat en silicium cristallin ;
- une première couche de passivation en silicium amorphe hydrogéné, disposée sur une première face du substrat ; et
- une première couche en silicium amorphe dopé de type n, disposée sur la première couche de passivation.

Le procédé comprend une étape d'exposition de l'empilement à un rayonnement électromagnétique émis par une source de rayonnement électromagnétique, la première face du substrat étant tournée vers la source de rayonnement électromagnétique, le rayonnement électromagnétique présentant au moins une première longueur d'onde comprise entre 300 nm et 550 nm, de préférence entre 400 nm et 550 nm, et au moins une deuxième longueur d'onde comprise entre 800 nm et 1100 nm et de manière préférée entre 900 nm et 1000 nm et le rayonnement électromagnétique présentant une irradiance spectrale entre 550 nm et 800 nm inférieure ou égale à 0.04 W/m$^2$/nm.

L'exposition de l'empilement au rayonnement électromagnétique a pour effet d'augmenter la tension de circuit ouvert Voc et le facteur de forme de la cellule photovoltaïque. Ainsi le rendement de conversion de la cellule photovoltaïque est amélioré. Par exemple, traiter l'empilement avec un rayonnement selon l'invention pendant 10 min permet d'obtenir un gain du rendement de conversion de la cellule photovoltaïque équivalent à 12h de traitement avec un rayonnement de même intensité (ou irradiance) mais ne présentant pas de longueur d'onde sur la plage 300 nm à 550 nm. La combinaison des première et deuxième longueurs d'ondes permet donc d'augmenter la cinétique de bonification du rendement de conversion.

Outre les caractéristiques qui viennent d'être évoquées dans le paragraphe précédent, l'invention selon le premier aspect peut présenter une ou plusieurs caractéristiques complémentaires parmi les suivantes, considérées individuellement ou selon toutes les combinaisons techniquement possibles.

Avantageusement, le rayonnement électromagnétique est constitué d'une première composante et d'une deuxième composante, la première composante étant comprise entre 300 nm et 550 nm et la deuxième composante étant comprise entre 550 nm et 1100 nm, au moins l'une des première et deuxième composantes étant monochromatique. De préférence, ladite au moins une première longueur d'onde appartient à la première composante et ladite au moins une deuxième longueur d'onde appartient à la deuxième composante,

Avantageusement, le rayonnement électromagnétique présente :

- une première irradiance mesurée sur la plage de longueurs d'onde comprise entre 300 nm et 550 nm ;
- une deuxième irradiance mesurée sur la plage de longueurs d'onde comprise entre 550 nm et 1100 nm ;
- une irradiance totale mesurée sur la plage de longueurs d'onde comprise entre 300 nm et 1100 nm ; et

la première irradiance étant supérieure à 10 % de l'irradiance totale.

Avantageusement, la première irradiance est mesurée sur la plage de longueurs d'onde comprise entre 400 nm et 550 nm et de préférence entre 400 nm et 450 nm.

Avantageusement, la deuxième irradiance est mesurée sur la plage de longueurs d'onde comprise entre 800 nm et 1100 nm et le rayonnement électromagnétique présente une troisième irradiance mesurée sur la plage de longueurs d'onde comprise entre 550 nm et 800 nm inférieure ou égale à 0,1 kW/m$^2$.

Avantageusement, la première irradiance est associée à la première composante et la deuxième irradiance est associée à la deuxième composante.

Avantageusement, l'irradiance totale du rayonnement électromagnétique est supérieure ou égale à 1 kW/m$^2$, de préférence supérieure ou égale à 1,3 kW/m$^2$ et de manière encore préférée supérieure ou égale à 5 kW/m$^2$.

Avantageusement, le rayonnement électromagnétique comprend un premier flux de photons dont la longueur d'onde est comprise entre 300 nm et 550 nm et un deuxième flux de photons dont la longueur d'onde est comprise entre 550 nm et 1100 nm, le rapport du premier flux de photons par le deuxième flux de photons étant inférieur ou égal à 70/30.

Avantageusement, la longueur d'onde du deuxième flux de photons est comprise entre 800 nm et 1100 nm.

Avantageusement, le premier flux de photons est associé à la première composante et la deuxième flux de photons est associé à la deuxième composante.

Avantageusement, le rayonnement électromagnétique comprend un flux total de photons égal à la somme du premier flux de photons et du deuxième flux de photons, le flux total de photons étant supérieur ou égal à $4,83871 \times 10^{21}$ m$^{-2} \cdot$s$^{-1}$ et de préférence supérieur ou égal à $8,95161 \times 10^{21}$ m$^{-2} \cdot$s$^{-1}$.

Avantageusement, la température de l'empilement est inférieure à 320 °C lors de l'étape d'exposition au rayonnement électromagnétique et préférentiellement inférieure à 250 °C, voire 200 °C.

Avantageusement, la température de l'empilement est inférieure à une température maximale lors de l'étape d'exposition au rayonnement électromagnétique et préférentiellement inférieure à une température critique.

Avantageusement, la température de l'empilement lors de l'étape d'exposition au rayonnement électromagnétique (20) est sensiblement égale à 100°C.

3

Préférentiellement, l'étape d'exposition est continue.

Avantageusement, l'étape d'exposition est réalisée par séquences afin de limiter l'échauffement de l'empilement.

Avantageusement, l'empilement comprend en outre une couche d'oxyde transparent conducteur disposée sur la première couche en silicium amorphe dopé.

Avantageusement, l'empilement comprend :

- une deuxième couche de passivation en silicium amorphe hydrogéné, disposée sur une deuxième face du substrat, la deuxième face du substrat étant opposée à la première face du substrat ; et
- une deuxième couche en silicium amorphe dopé de type p, disposée sur la deuxième couche de passivation.

Avantageusement, l'empilement comprend en outre une deuxième couche en silicium amorphe dopé de type p, la deuxième couche en silicium amorphe dopé étant également disposée sur la première couche de passivation.

L'invention concerne en outre un procédé de fabrication d'une cellule à hétérojonction de silicium, comprenant les étapes suivantes :

- former un empilement en déposant une première couche de passivation en silicium amorphe hydrogéné sur une première face d'un substrat en silicium cristallin et une première couche en silicium amorphe dopé de type n sur la première couche de passivation ; et
- exposer l'empilement à un rayonnement électromagnétique émis par la source de rayonnement électromagnétique, la première face du substrat étant tournée vers la source de rayonnement électromagnétique, le rayonnement électromagnétique présentant au moins une première longueur d'onde comprise entre 300 nm et 550 nm et au moins une deuxième longueur d'onde comprise entre 800 nm et 1100 nm et le rayonnement électromagnétique présentant une irradiance spectrale entre 550 nm et 800 nm inférieure ou égale à 0.04 W/m$^2$/nm.

Le procédé de fabrication permet de fournir une cellule à hétérojonction de silicium bonifiée, c'est à dire présentant un meilleur rendement de conversion. L'exposition au rayonnement électromagnétique comprenant deux longueurs d'onde permet d'augmenter la cinétique de bonification. Ainsi, le procédé permet de fabriquer des cellules à hétérojonction bonifiées à une cadence industrielle.

L'invention concerne également un procédé de traitement d'un module photovoltaïque, le module photovoltaïque comprenant au moins deux cellules photovoltaïques à hétérojonction de silicium connectés électriquement, chaque cellule photovoltaïque à hétérojonction de silicium comprenant un empilement, l'empilement comprenant :

- un substrat en silicium cristallin ;
- une première couche de passivation en silicium amorphe hydrogéné, disposée sur une première face du substrat ; et
- une première couche en silicium amorphe dopé de type n, disposée sur la première couche de passivation ;

Le procédé de traitement du module photovoltaïque étant remarquable en ce qu'il comprend une étape d'exposition de chaque empilement à un rayonnement électromagnétique émis par une source de rayonnement électromagnétique, chaque première face du substrat étant tournée vers la source de rayonnement électromagnétique, le rayonnement électromagnétique présentant au moins une première longueur d'onde comprise entre 300 nm et 550 nm et au moins une deuxième longueur d'onde comprise entre 800 nm et 1100 nm, et le rayonnement électromagnétique présentant une irradiance spectrale entre 550 nm et 800 nm inférieure ou égale à 0.04 W/m$^2$/nm.

Le procédé de traitement permet de bonifier les cellules à hétérojonctions formant le module photovoltaïque. Le procédé peut être mis en œuvre avant que les cellules à hétérojonctions ne soient encapsulées ou après encapsulation. Dans ce dernier, il s'agit par exemple des cellules à hétérojonction formant un module photovoltaïque fini. Le procédé de traitement appliqué à un module photovoltaïque fini permet d'augmenter le rendement de conversion dudit module photovoltaïque lorsqu'il en fin de fabrication ou après installation.

L'invention et ses différentes applications seront mieux comprises à la lecture de la description qui suit et à l'examen des figures qui l'accompagnent.

**BRÈVE DESCRIPTION DES FIGURES**

Les figures sont présentées à titre indicatif et nullement limitatif de l'invention.

[Fig. 1] est une vue schématique en perspective d'un exemple de cellule photovoltaïque à hétérojonction.
[Fig. 2] représente schématiquement un procédé de traitement d'un empilement selon le premier aspect de l'invention.

[Fig. 3] représente deux courbes d'irradiances spectrales de trois rayonnements électromagnétiques émis de trois sources différentes.

[Fig. 4] représente deux courbes de rendement d'empilements ayant subi le procédé de traitement.

[Fig. 5] représente le gain de rendement d'un empilement ayant subi le procédé de traitement.

[Fig. 6] représente l'irradiance reçue par un empilement en fonction d'un rapport de flux de photons.

[Fig. 7] représente l'évolution de la température d'un empilement en fonction de la densité de puissance absorbée et du rapport des flux de photons.

Pour plus de clarté, les éléments identiques ou similaires sont repérés par des signes de référence identiques sur l'ensemble des figures.

## DESCRIPTION DÉTAILLÉE

La figure 2 représente schématiquement un procédé de traitement d'un empilement 10' servant à fabriquer une cellule photovoltaïque à hétérojonction. L'empilement 10' peut être un précurseur de cellule photovoltaïque à hétérojonction, c'est-à-dire un produit intermédiaire obtenu au cours de la fabrication d'une cellule photovoltaïque à hétérojonction, ou une cellule photovoltaïque à hétérojonction finalisée (c.-à-d. prête à être interconnectée avec d'autres cellules photovoltaïques à hétérojonction). L'empilement 10' comprend un substrat 11 en silicium cristallin (c-Si), une première couche de passivation 14 disposée sur une première face 11a du substrat 11 et une première couche en silicium amorphe dopé 12 disposée sur la première couche de passivation 14.

Le substrat 11 en silicium cristallin peut être dopé de type n ou de type p. Lorsque le substrat 11 en silicium cristallin est dopé de type n, seules des impuretés dopantes de type donneur (par exemple des atomes de phosphore) ont été volontairement introduites dans le silicium cristallin du substrat 11 afin de modifier sa conductivité électrique. Outre des impuretés dopantes de type donneur, le substrat 11 peut contenir, de façon non intentionnelle (et donc à l'état de traces), des impuretés dopantes de type accepteur (telles que des atomes de bore). La concentration en impuretés dopantes de type accepteur $N_A$ du substrat 11 est avantageusement inférieure à $10^{13}$ cm$^{-3}$, de préférence inférieure à $3 \cdot 10^{12}$ cm$^{-3}$. La concentration en impuretés dopantes de type donneur $N_D$ est de préférence supérieure à 50 fois la concentration en impuretés dopantes de type accepteur $N_A$ (ou $N_D/N_A > 50$). De la même manière, lorsque le substrat 11 en silicium cristallin est dopé de type p, seules des impuretés dopantes de type accepteur ont été volontairement introduites, comme par exemple des atomes de bore, de gallium ou d'indium.

La première couche de passivation 14 est en silicium amorphe hydrogéné (a-Si:H). Le silicium amorphe hydrogéné de la première couche de passivation 14 est de préférence intrinsèque, c'est-à-dire non intentionnellement dopé. Le silicium amorphe hydrogéné intrinsèque permet en effet une meilleure passivation chimique des surfaces de silicium cristallin que le silicium amorphe hydrogéné dopé.

La première couche en silicium amorphe dopé 12 est dopée de type n, par exemple par l'introduction d'impuretés de type donneur, telles que des atomes de phosphore. De la même manière que le substrat 11, outre des impuretés dopantes de type donneur, la première couche en silicium amorphe dopé 12 peut contenir, de façon non intentionnelle, des impuretés dopantes de type accepteur, à l'état de traces.

En référence à la figure 2, le procédé de traitement comprend une étape d'exposition de l'empilement 10' à un rayonnement électromagnétique 20 pendant une durée de traitement t qui est avantageusement fonction de l'irradiance totale E du rayonnement électromagnétique 20 et de la longueur d'onde $\lambda$ (ou des longueurs d'onde) du rayonnement électromagnétique 20. L'irradiance totale E, appelée aussi éclairement énergétique ou densité surfacique de puissance lumineuse, représente la puissance du rayonnement électromagnétique reçue par une unité de surface, cette unité de surface étant orientée perpendiculairement à la direction du rayonnement électromagnétique.

L'étape d'exposition, aussi appelée étape d'illumination ou d'irradiation, peut être accomplie en disposant l'empilement 10' sur un support 30 et sous une source de rayonnement 40. Le rayonnement électromagnétique 20 émis par la source 40 est de préférence dirigé perpendiculairement à la surface de l'empilement 10'.

La première face 11a du substrat 11, recouverte de la première couche de passivation 14 et de la première couche en silicium amorphe dopé 12, est tournée vers la source de rayonnement 40, comme illustré par la figure 2.

L'exposition de l'empilement 10' au rayonnement électromagnétique 20 a pour effet de d'augmenter la tension de circuit ouvert Voc et le facteur de forme (FF) de la cellule photovoltaïque obtenue à partir de l'empilement 10' et par conséquent augmenter son rendement de conversion.

Afin d'améliorer le rendement de conversion de la cellule, il n'est pas utile d'exposer plus d'une face de l'empilement 10' au rayonnement électromagnétique 20. En revanche, cette face de l'empilement 10' peut être illuminée entièrement. De préférence, toutes les régions de la face exposée de l'empilement 10' reçoivent le rayonnement électromagnétique 20 pendant la même durée de traitement t.

Le support 30 peut être fixe ou mobile et conçu pour supporter un ou plusieurs empilements (10'). Il peut être couplé à un système de refroidissement (non représenté), afin de maintenir la température de l'empilement 10' en dessous de 320 °C lorsque la durée de traitement entre 200 °C et 320 °C ne dépasse pas 1 seconde et préférentiellement en dessous de 200 °C pendant toute la durée du traitement t. En effet, après plusieurs secondes passées au-delà de 200 °C, le silicium amorphe de la première couche de passivation 14 se dégrade de façon irrémédiable, entraînant une diminution des performances de la cellule photovoltaïque. Toutefois la durée de traitement entre 200 °C et 320 °C avant dégradation de la première couche de passivation 14 peut varier positivement ou négativement selon le procédé de dépôt utilisé. Le support 30 est par exemple refroidi en faisant circuler un fluide caloporteur ou grâce à des éléments Peltier.

De façon encore plus avantageuse, la température de l'empilement 10' est maintenue inférieure ou sensiblement égale à 200 °C. Par l'expression "maintenir la température sensiblement égale à 200 °C", on entend que la température maximale de l'empilement 10' est comprise dans une plage de $\pm 5\%$ autour de 200 °C, c'est-à-dire comprise entre 190 °C et 210 °C.

De manière avantageuse, la température de l'empilement 10' est maintenue en dessous d'une température maximale et préférentiellement en dessous d'une température critique. La température maximale correspond à la température au-delà de laquelle l'empilement 10' subit instantanément des dommages irréversibles. La température critique correspond à la plus haute température permettant de ne pas endommager l'empilement 10', quel que soit la durée de maintien à cette température. L'empilement 10' peut supporter une température comprise entre la température critique et la température maximale, en revanche la durée d'exposition à cette température est limitée. Par exemple, ladite durée est inférieure à 1 s lorsque la température de l'empilement est sensiblement inférieure à la température maximale. Ladite durée peut être supérieure à plusieurs secondes, par exemple de quelques minutes, lorsque la température de l'empilement est sensiblement supérieure à la température critique. En effet, au-delà d'une certaine quantité d'énergie accumulée, le silicium amorphe de la première couche de passivation 14 se dégrade de façon irrémédiable, entraînant une diminution des performances de la cellule photovoltaïque. La température critique peut varier positivement ou négativement selon le procédé de dépôt utilisé. Par exemple, certains procédés de dépôt permettent de fournir des empilements 10' présentant une température critique égale à 250 °C. En revanche, la température critique est rarement observée inférieure à 200 °C. La température critique est alors préférentiellement comprise entre 200 °C et 250 °C, par exemple comprise entre 230 °C et 240 °C. La température maximale, quant à elle, varie peu en fonction du procédé de dépôt utilisé et est par exemple égale à 320 °C.

Le système de refroidissement (non représenté), maintient alors avantageusement la température de l'empilement 10' en dessous de la température critique pendant toute la durée du traitement et préférentiellement la température de l'empilement 10' entre la température critique et la température maximale pendant moins d'une seconde.

De façon encore plus avantageuse, la température de l'empilement 10' est maintenue inférieure ou sensiblement égale à la température critique. Par l'expression "maintenir la température sensiblement égale à la température critique", on entend que la température maximale de l'empilement 10' est comprise dans une plage de $\pm 5\%$ autour de la température critique, par exemple comprise entre 240 °C et 260 °C lorsque la température critique est égale à 250 °C.

Le support 30 peut notamment être un porte-substrat ou un convoyeur capable de transporter plusieurs empilements 10' simultanément.

La source de rayonnement 40 peut être un système laser comprenant par exemple une ou plusieurs matrices de lasers, un ensemble de diodes électroluminescentes ou tout autre dispositif capable d'émettre un rayonnement électromagnétique dont l'irradiance totale E est avantageusement supérieure à 1 kW·m$^{-2}$. Préférentiellement l'irradiance totale E est supérieure à 1,3 kW·m$^{-2}$ et encore préférentiellement supérieure à 5 kW·m$^{-2}$, par exemple égale à 200 kW·m$^{-2}$.

Un système de déplacement du support 30 ou de la source 40 peut être prévu afin d'animer le support 30 et la source 40 d'un mouvement relatif de translation. Un tel système de translation permet d'exposer toute une face de l'empilement 10' dans le cas d'une source 40 ayant une surface d'illumination inférieure à la superficie de la face de l'empilement 10' (cas d'un système laser notamment). Il permet également d'illuminer plusieurs empilements 10' successivement, ces empilements étant par exemple disposés sur le même support.

Le rayonnement électromagnétique 20 peut être polychromatique, c'est-à-dire comporter plusieurs composantes (monochromatiques) de longueurs d'ondes différentes.

Plus précisément, le rayonnement électromagnétique 20 présente au moins une première longueur d'onde comprise entre 300 nm et 550 nm et de préférence entre 400 nm et 550 nm et de manière encore préférée entre 400 nm et 450 nm. Dans ces plages, le rayonnement est absorbé au moins en partie dans les premières centaines de nanomètres de l'empilement 10', ce qui permet d'améliorer la qualité de la première couche de passivation 14 en silicium amorphe hydrogéné et la première couche dopée 12 en silicium amorphe. Les très courtes longueurs d'onde, inférieures à 400 nm, sont très énergétiques et peuvent présenter un risque de dégradation pour la couche de passivation auquel cas restreindre la plage de longueur d'onde entre 400 nm et 550 nm permet de limiter le risque de dégradation. Plus la longueur d'onde du rayonnement est grande et moins le rayonnement est absorbé efficacement. Une plage de longueur d'onde comprise entre 400 et 450 nm représente un bon compromis en termes d'absorption (et donc d'efficacité de traitement) et de limitation des risques pour la couche de passivation.

Le rayonnement électromagnétique 20 peut également présenter au moins une deuxième longueur d'onde comprise entre 800 nm et 1100 nm. Dans cette plage, le rayonnement est absorbé au moins en partie dans le substrat cristallin, ce qui a pour effet de diminuer le nombre d'états d'interface entre le substrat cristallin 11 et respectivement les première et deuxième couches de passivation 14. Autrement dit, le nombre de défauts d'interface neutralisés augmente et la qualité de la passivation s'améliore. Afin d'augmenter l'absorption du rayonnement électromagnétique 20, la deuxième longueur d'onde est préférentiellement comprise entre 900 nm et 1100 nm. Entre 1000 nm et 1100 nm, la transparence de l'empilement 10' augmente, réduisant l'efficacité du procédé, ainsi il peut être avantageux que la deuxième longueur d'onde soit comprise entre 900 nm et 1000 nm.

Réaliser le traitement uniquement avec un rayonnement ne comprenant que la première longueur d'onde permet d'améliorer la qualité des couches amorphes 12, 14, toutefois le rayonnement de courtes longueurs d'onde peut provoquer un échauffement excessif de l'empilement 10'. Afin de limiter l'échauffement, l'intensité du rayonnement ne comprenant que la première longueur d'onde peut être réduit, afin de réduire également l'échauffement. En revanche, cette solution réduit également la cinétique d'amélioration des couches amorphes 12, 14. A intensité égale, le rayonnement 20 comprenant la première longueur d'onde et la deuxième longueur d'onde offre l'avantage de réduire l'intensité associée à la première longueur d'onde, réduisant ainsi l'échauffement associé à la première longueur d'onde, qui n'est pas annulé par l'échauffement associé à la deuxième longueur d'onde. Le rayonnement 20 bénéficie ainsi des améliorations liées à la première longueur d'onde et à la deuxième longueur d'onde, offrant ainsi une cinétique d'amélioration élevée tout en limitant l'échauffement de l'empilement 10'.

Afin d'améliorer davantage la cinétique de traitement tout en limitant l'échauffement, il est avantageux que le rayonnement électromagnétique 20 soit négligeable, voire nul, entre 550 nm et 800 nm. En effet, sur cette plage de longueurs d'onde, l'efficacité de traitement de la première couche de passivation 14 et de la première couche dopée 12 est moindre alors que l'échauffement provoqué est encore important. Il est donc préférable de limiter l'apport énergétique entre 550 nm et 800 nm. Pour cela, le rayonnement électromagnétique 20 présente préférentiellement une irradiance spectrale entre 550 nm et 800 nm négligeable, c'est à dire inférieure ou égale à 0,04 W/m$^2$/nm. Une irradiance spectrale inférieure ou égale à 0,04 W/m$^2$/nm peut être obtenue par filtrage du rayonnement électromagnétique, coupant toutes les longueurs d'onde entre 550 nm et 800 nm.

La deuxième longueur est comprise entre 800 nm et 1100 nm.

Le rayonnement électromagnétique 20, qu'il soit monochromatique ou polychromatique, présente une première irradiance $E_A$ et une deuxième irradiance $E_B$ comme illustré par la figure 3. La première irradiance $E_A$ est mesurée sur la plage de longueurs d'onde comprise entre 300 nm et 550 nm. La deuxième irradiance $E_B$ est mesurée sur la plage de longueurs d'onde comprise entre 550 nm et 1100nm. L'irradiance spectrale $E(\lambda)$ est fonction de la longueur d'onde $\lambda$ et exprimée en W/m$^2$/nm. La première irradiance $E_A$ correspond à l'intégration de l'irradiance spectrale $E(\lambda)$ entre 300 nm et 550 nm. De la même manière, la deuxième irradiance $E_B$ correspond à l'intégration de l'irradiance spectrale $E(\lambda)$ entre 550 nm et 1100 nm.

À titre d'exemple, la figure 3 présente deux courbes d'irradiances spectrales $E(\lambda)$, de deux rayonnements électromagnétiques émis par des sources différentes. La courbe en trait plein représente l'irradiance spectrale $E(\lambda)$ d'un rayonnement émis par une source au xénon non filtrée (appelée ci-après rayonnement non filtré). La courbe en trait interrompu représente l'irradiance spectrale $E(\lambda)$ d'un rayonnement émis par une source au xénon filtrée (appelée ci-après rayonnement filtré). Les rayonnements filtré et non filtré sont émis par la même source comprenant dans le premier cas, un filtre optique coupant les longueurs d'onde inférieures à 550 nm, et dans le deuxième cas, aucun filtre optique.

Le rayonnement non filtré (trait plein) présente une irradiance spectrale $E(\lambda)$ non-nulle entre 300 nm et 550 nm et supérieure à 0.4 W/m$^2$/nm entre 350 nm et 550 nm. Le rayonnement filtré (trait interrompu) présente une irradiance spectrale $E(\lambda)$ négligeable entre 300 nm et 550 nm. Les rayonnements filtré et non filtré présentent sensiblement (à $\pm5\%$ près) les même valeurs d'irradiance spectrale $E(\lambda)$ entre 650 nm et 1100 nm.

Les plages de longueurs d'onde associées aux première et deuxième irradiances $E_A$, $E_B$ sont hachurées et différentiées par les lettres A et B dans la figure 3. L'irradiance totale E est mesurée sur la plage de longueurs d'onde comprise entre 300 nm et 1100 nm, recouvrant les plages A et B. Le rayonnement non filtré présente une première irradiance $E_A$ et une deuxième irradiance $E_B$ non-nulles. Le rayonnement filtré présente une première irradiance $E_A$ négligeable et une deuxième irradiance $E_B$ sensiblement égale (à $\pm5$ % près) à la deuxième irradiance $E_B$ du rayonnement non filtré.

Il est avantageux de définir une troisième irradiance, mesurée entre 550 nm et 800 nm. La troisième irradiance correspond préférentiellement à l'intégration de l'irradiance spectrale $E(\lambda)$ entre 550 nm et 800 nm. La deuxième irradiance $E_B$ est alors préférentiellement mesurée entre 800 nm et 1100 nm.

Afin de réduire l'échauffement lors du traitement thermique tout en améliorant la cinétique de traitement, la troisième irradiance est préférentiellement inférieure ou égale à 0,1 kW/m$^2$. La troisième irradiance est par exemple obtenue par filtrage du rayonnement électromagnétique coupant toutes les longueurs d'onde dans une fenêtre s'étendant de 550 nm à 800 nm de sorte que l'irradiance spectrale maximum du rayonnement soit inférieure ou égale à 0,04 W/m$^2$/nm.

Le traitement thermique au moyen d'un rayonnement électromagnétique similaire au rayonnement solaire est moins avantageux. En effet, une source de rayonnement suivant le standard AM1.5 G ("Air Mass 1.5 Global" en anglais) émet un rayonnement électromagnétique dont une forte partie de l'énergie émise est comprise entre 550 nm et 800 nm. Or, les photons dans cette gamme contribuent moins efficacement à l'amélioration des caractéristiques photo-électroniques de l'empilement mais provoquent en revanche un échauffement important. Il est alors nécessaire de refroidir activement l'empilement au moyen d'un système de refroidissement ou alors réduire l'irradiance totale émise, réduisant davantage la cinétique du traitement. Ainsi, limiter l'irradiance spectrale entre 550 nm et 800 nm à 0,04 W/m²/nm, c'est à dire à une irradiance inférieure ou égale à 0,1 kW/m², permet d'améliorer la cinétique de traitement tout en simplifiant la mise en œuvre du procédé (absence de moyen de refroidissement par exemple).

L'empilement 10' comprend avantageusement une deuxième couche de passivation (non représentée sur la figure 2) disposée sur une deuxième face 11b du substrat 11, opposée à la première face 11a. La deuxième couche de passivation peut être en silicium amorphe hydrogéné intrinsèque, nitrure de silicium, oxyde d'aluminium, oxyde de titane ou oxyde de silicium. À l'instar de la première couche de passivation 14, la deuxième couche de passivation contribue à réduire le nombre de recombinaisons des paires électron-trou en surface du substrat 11, augmentant ainsi le niveau d'injection dans l'empilement 10' lors de l'étape d'illumination (et du fonctionnement ultérieur de la cellule photovoltaïque).

L'empilement 10' peut également comprendre une deuxième couche de silicium amorphe, dopé de type p (similaire à la deuxième couche de silicium amorphe 13 représentée sur la figure 1), destinée à former l'émetteur de la cellule photovoltaïque et disposée sur la deuxième couche de passivation.

Dans un mode de mise en œuvre du procédé de traitement, l'empilement 10' est du type représenté sur la figure 1 et comprend :

- le substrat 11 en silicium cristallin ;

- la première couche de passivation 14 en silicium amorphe hydrogéné (et de préférence intrinsèque) disposée sur la première face 11a du substrat 11 ;

- la première couche de silicium amorphe dopé 12, disposée sur la première couche de passivation 14 et dopée de type n ;

- une première couche d'oxyde transparent conducteur 15 disposée sur la première couche dopée de silicium amorphe dopé 12 ;

- la deuxième couche de passivation 14 en silicium amorphe hydrogéné (et de préférence intrinsèque) disposée sur la deuxième face 11b du substrat 11 ;

- la deuxième couche de silicium amorphe dopé 13, disposée sur la deuxième couche de passivation 14 et dopé de type p ; et

- une deuxième couche d'oxyde transparent conducteur 15 disposée sur la deuxième couche dopée de silicium amorphe dopé 13.

Un tel empilement ou précurseur de cellule photovoltaïque à hétérojonction est qualifié d'asymétrique en raison des deux couches de silicium amorphe dopé 12, 13, dopé de types de conductivité opposés et disposées de part et d'autre du substrat 11. Le silicium amorphe des première et deuxième couches dopées 12, 13 est de préférence hydrogéné.

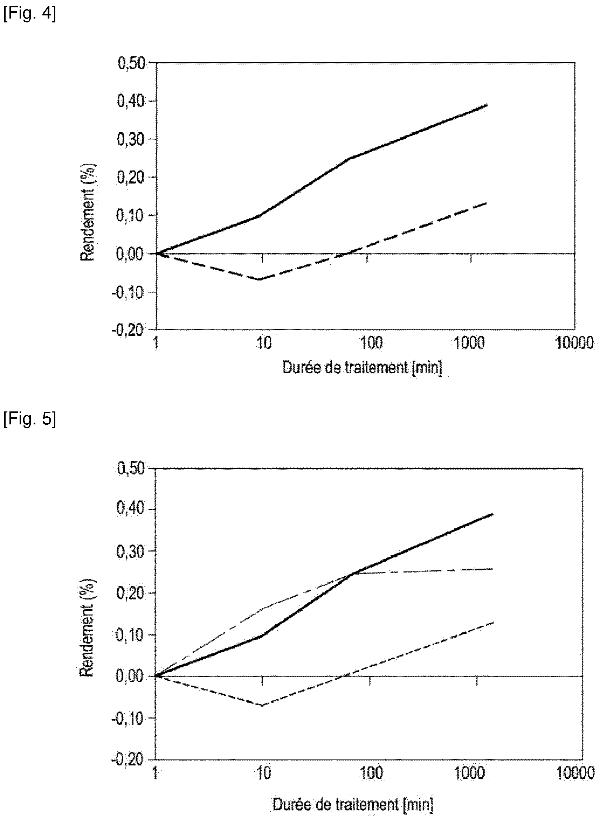

La figure 4 présente les moyennes de gains en rendement de conversion d'une pluralité d'empilements 10', une partie de ladite pluralité ayant subi un traitement mettant en œuvre le rayonnement non filtré (trait plein) et l'autre partie de ladite pluralité ayant subi un traitement mettant en œuvre le rayonnement filtré (trait interrompu). Les rayonnements présentent des irradiances totales E comprise entre 1 kW/m² et 3 kW/m², toutefois les résultats de la figure 4 restent valables pour de plus fortes irradiances, par exemple supérieure à 5 kW/m², tant que la température des empilements 10' est maintenu inférieure à 320 °C et préférablement inférieure ou sensiblement égale à 200 °C. Il est d'ailleurs plus avantageux que la température des empilements 10' soit maintenue inférieure à la température maximale et préférablement inférieure ou sensiblement égale à la température critique.

Les moyennes des gains en rendements sont reportées en fonction de la durée de traitement t et sont normalisées à zéro avant le traitement. Dans les deux cas, les empilements traités sont maintenus au même température.

Les empilements 10' traités avec le rayonnement filtré (trait interrompu) voient une réduction de leurs rendements lors des premières minutes de traitement et une augmentation de leurs rendements au-delà d'une heure de traitement pour présenter un gain moyen supérieure à 0,1 % après 24 heures de traitement. Les empilements 10' traités avec le rayonnement non filtré (trait plein) présentent une augmentation de leurs rendements dès les premières minutes de traitement et présentent un gain moyen de 0,1 % après 10 minutes de traitement seulement. L'augmentation du rendement se poursuit en fonction de la durée de traitement pour présenter un gain moyen en rendement sensiblement égal à 0,4 % après 24 h de traitement.

A titre d'exemple, traiter un empilement 10' avec un rayonnement non filtré pendant 10 min permet d'obtenir un gain en rendement équivalent à 24 h de traitement avec un rayonnement filtré. La différence entre les rayonnements filtrés et non filtrés est la présence d'au moins une composante de longueur d'onde comprise entre 300 nm et 550 nm pour le rayonnement non filtré. Ainsi, la mise en œuvre dans le procédé de traitement d'un rayonnement présentant au moins une longueur d'onde comprise entre 300 nm et 550 nm permet d'augmenter la cinétique du gain en rendement de conversion et donc de réduire la durée du traitement, rendant ainsi le traitement compatible avec une cadence industrielle.

La figure 5 montre l'influence de la première irradiance $E_A$ sur les moyennes des gains de rendements obtenus dans la figure 4, en d'autres termes, l'influence d'au moins une première longueur d'onde comprise entre 300 nm et 550 nm. L'augmentation du rendement, lorsque le procédé de traitement met en œuvre un rayonnement non-filtré (trait plein), comprend d'une part un gain associé à la première irradiance $E_A$ et d'autre part un gain associé à la seconde irradiance $E_B$. Pour cela, une comparaison (soustraction) est effectuée entre les moyennes des gains de rendements obtenus par la mise en œuvre des rayonnements filtré (trait interrompu) et non filtré (trait plein) permettant d'obtenir l'augmentation de rendement résultant uniquement de la première irradiance $E_A$. Le rendement associé à la première irradiance $E_A$ est matérialisé par la courbe en trait mixte. L'augmentation du rendement associé à la première irradiance $E_A$ est effectif dès les premières minutes de traitement, permettant notamment de compenser la réduction de rendement due à la deuxième irradiance $E_B$. Ainsi, le traitement d'un empilement 10' par un rayonnement comprenant au moins une longueur d'onde comprise entre 300 nm et 550 nm permet d'augmenter le rendement de l'empilement 10'.

Les longueurs d'onde inférieures à 550 nm sont absorbées par les premières centaines de nanomètres de l'empilement et interagissent avec les couches supérieures de l'empilement 10', c'est à dire la première couche de passivation 14, la première couche en silicium amorphe dopé 12 et, selon un mode de réalisation du procédé, la première couche d'oxyde transparent conducteur 15. L'énergie dissipée par les courtes longueurs d'onde a pour effet d'améliorer la qualité des couches 12, 14, 15 ainsi que les interfaces entre ces couches réduisant ainsi la résistance en série au sein de l'empilement 10'. La réduction de la résistance en série de l'empilement 10' augmente le facteur de forme de la cellule photovoltaïque et son rendement de conversion.

L'empilement 10' peut comprendre, en plus de la première couche d'oxyde transparent conducteur 15, des métallisations 16, disposées sur la première couche d'oxyde transparent conducteur 15. L'énergie dissipée dans la première couche d'oxyde transparent conducteur 15 permet également d'améliorer l'interface entre la première couche d'oxyde transparent conducteur 15 et les métallisations 16, réduisant davantage la résistance en série au sein de l'empilement 10'.

La mise en œuvre d'un rayonnement 20 comprenant au moins une longueur d'onde comprise entre 300 nm et 550 nm permet de réduire la durée du traitement t. Toutefois, les photons de courtes longueurs d'onde sont énergétiques et présentent une forte probabilité d'absorption, échauffant ainsi l'empilement 10'. Afin de ne pas dégrader les couches en silicium amorphe 12, 13, 14, il est préférable de limiter la température de l'empilement 10' à moins de 200 °C. Toutefois, selon le procédé de fabrication pour déposer les couches en silicium amorphe 12, 13, 14 et leur qualité, la limite de température de l'empilement 10' n'entrainant de dégradation peut dépasser légèrement 200 °C, pouvant par exemple atteindre 235 °C. Lorsqu'une dégradation des couches en silicium amorphe est à craindre, la température de l'empilement 10' peut toutefois être comprise entre 200 °C et 270 °C pendant 10 minutes ou être comprise entre 270 °C et 280 °C pendant 2 secondes ou encore être comprise entre 280 °C et 320 °C, pendant 1 seconde au maximum.

Afin de ne pas dégrader les couches en silicium amorphe 12, 13, 14, il peut également être avantageux de limiter la température de l'empilement 10' inférieure à la température critique. Toutefois, selon le procédé de fabrication pour déposer les couches en silicium amorphe 12, 13, 14 et leur qualité, la limite de température critique peut varier. La température de l'empilement 10' est préférentiellement comprise entre la température critique et 270 °C pendant 10 minutes ou être comprise entre 270 °C et 280 °C pendant 2 secondes ou encore comprise entre 280 °C et la température maximale, pendant 1 seconde au maximum.

Les puissances dissipées par le rayonnement 20 en fonction de la longueur d'onde peuvent être ajustées pour limiter l'échauffement de l'empilement 10'. La première irradiance $E_A$ peut par exemple être réduite au profit de la deuxième irradiance $E_B$. Par exemple la première irradiance $E_A$ peut représenter 10 % à 30 % de l'irradiance totale $E$. Toutefois, afin de conserver une bonne cinétique de bonification, la première irradiance $E_A$ est avantageusement conservée supérieure à 10 % de l'irradiance totale $E$.

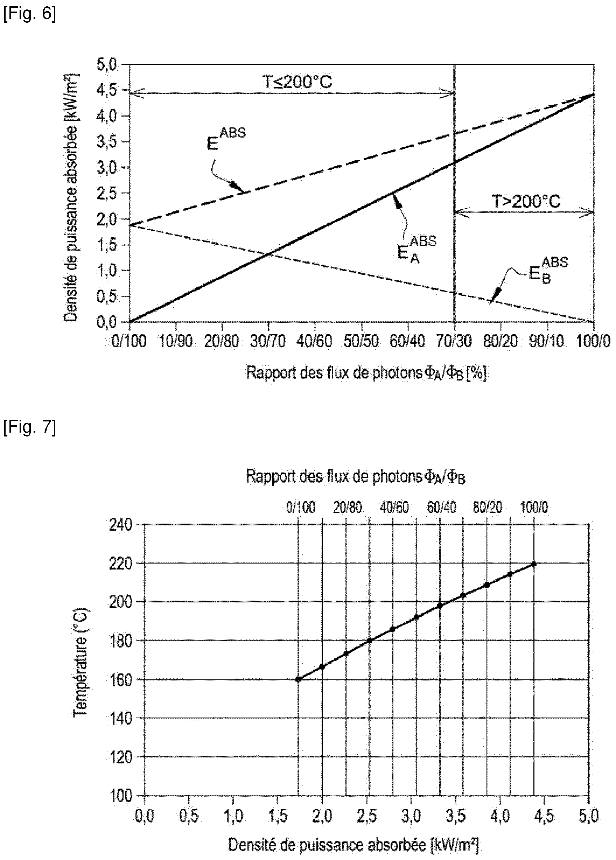

Les figures 6 et 7 montrent des résultats de simulation de l'échauffement de l'empilement 10' du type de la figure 1 traité par un rayonnement 20 comprenant seulement deux composantes monochromatiques, une première longueur d'onde égale à 400 nm et une deuxième longueur d'onde égale à 1000 nm. Le rayonnement présente un flux total de photons absorbés $\phi_T$ constant et égal à $8,95161 \times 10^{21}$ photon/m$^2$/s. Le flux total de photons absorbés $\phi_T$ comprend un premier flux de photons absorbés $\phi_A$ présentant une première longueur d'onde de 400 nm et un deuxième flux de photons absorbés $\phi_B$ présentant une deuxième longueur d'onde de 1000 nm. Le flux total de photons absorbés $\phi_T$ est égal à $\phi_T = \phi_A + \phi_B$ et est constant. La figure 6 présente notamment la densité de puissance absorbée ou irradiance totale absorbée $E^{ABS}$ du rayonnement 20 en fonction du rapport entre le premier et le deuxième flux de photons absorbés $\phi_A/\phi_B$. La première

irradiance absorbée $E_A^{ABS}$ dépend de l'irradiance $E_A$ (comprenant les irradiances absorbée, transmise et réfléchie) et du premier flux de photons absorbés $\phi_A$ selon :

[Math 1]

$$E_A^{ABS} \;\; = \;\; E_A \; \times \; \text{coefficient d'absorption} = \phi_A \; \times \; \frac{hc}{\lambda_{400}}$$

De la même manière, la deuxième irradiance absorbée $E_B^{ABS}$ dépend de l'irradiance $E_B$ (comprenant les irradiances absorbée, transmise et réfléchie) et du deuxième flux de photons absorbés $\phi_B$ selon :

[Math 2]

$$E_B^{ABS} \;\; = \;\; E_B \; \times \; \text{coefficient d'absorption} = \phi_B \times \frac{hc}{\lambda_{1000}}$$

La figure 6 présente la première irradiance absorbée $E_A^{ABS}$, représentée en trait plein, la deuxième irradiance absorbée $E_B^{ABS}$, représentée en trait interrompu fin et l'irradiance totale absorbée $E^{ABS}$, représentée en trait interrompu fort, en fonction du rapport des flux de photons absorbés $\phi_A/\phi_B$. Les photons de courtes longueurs d'onde sont plus énergétiques que les photons de grandes longueurs d'onde, ce qui a pour conséquence une augmentation de l'irradiance totale absorbée $E^{ABS}$ lorsque le premier flux de photon $\phi_A$ augmente. Lorsque le rayonnement 20 ne comprend que des photons de longueurs d'onde égale à 1000 nm, c'est à dire lorsque le premier flux de photons absorbés $\phi_A$ est nul, l'irradiance totale absorbée $E^{ABS}$ est minimale et sensiblement égale à 1,8 kW/m². Lorsque le rayonnement 20 ne comprend que des photons de longueurs d'onde égale à 400 nm, c'est à dire lorsque le premier flux de photons absorbés $\phi_A$ est de 100 %, l'irradiance totale absorbée $E^{ABS}$ est maximale et sensiblement égale à 4,4 kW/m².

Le premier flux de photons $\phi_A$ présente préférentiellement des photons dont la longueur d'onde est comprise entre 300 nm et 550 nm. Le deuxième flux de photons $\phi_B$ présente préférentiellement des photons dont la longueur d'onde est comprise entre 550 nm et 1100 nm. Avantageusement, la longueur d'onde du deuxième flux de photons $\phi_B$ est comprise entre 800 nm et 1100 nm.

La figure 7 montre le résultat d'une simulation de l'évolution de la température d'un empilement 10' en fonction de la densité de puissance absorbée (ou irradiance totale absorbée) $E^{ABS}$ du rayonnement 20. L'irradiance totale absorbée $E^{ABS}$ varie en fonction du rapport des flux de photons absorbés $\phi_A/\phi_B$ qui est reporté sur une deuxième échelle. Lorsque le rapport de flux $\phi_A/\phi_B$ est inférieure ou égale à 70/30, la température de l'empilement est maintenue inférieure ou sensiblement égale à 200 °C pendant toute la durée du traitement t. Il n'est donc pas nécessaire d'employer un système de refroidissement pour contrôler la température de l'empilement 10'. Par exemple, lorsque le rapport de flux $\phi_A/\phi_B$ est égale à 10/90, la température atteinte par l'empilement 10' est inférieure à 170°C.

Lorsque le rapport des flux $\phi_A/\phi_B$ est supérieur à 70/30, la température de l'empilement est supérieure à 200 °C. Dans ce cas, il peut être nécessaire de recourir à un système de refroidissement afin d'abaisser la température de l'empilement 10' et limiter le risque de dégradation des couches en silicium amorphe 12, 13, 14. Le système de refroidissement peut mettre en œuvre un ou plusieurs mécanismes de transfert thermique tel que l'émission d'un rayonnement thermique, la convection naturelle avec l'air ambiant ou encore la conduction thermique avec le support 30.

Lorsque le rapport des flux $\phi_A/\phi_B$ dépasse 70/30, la température de l'empilement 10' est supérieure 200 °C, au moins pendant une partie de la durée de traitement t. Par exemple, lorsque le flux $\phi_A/\phi_B$ est égale à 100/0, la température de l'empilement 10' est de l'ordre de 218 °C à l'issue du traitement. Il est donc préférable de mettre en œuvre un système de refroidissement afin de maintenir la température de l'empilement 10' inférieure à 200 °C pendant la durée du traitement ou réduire la durée où la température de l'empilement excède 200°C. Le système de refroidissement peut consister en une circulation d'un fluide caloporteur au sein du support 30, la mise en contact de l'empilement 10' avec des éléments Peltier ou encore la circulation forcée d'un gaz permettant d'évacuer la chaleur par convection forcée. De cette manière la dégradation des couches en silicium amorphe 12, 13, 14 peut être évitée ou réduite. Dans tous les cas, on veillera à ce que la température de l'empilement 10' reste inférieure à 320 °C, température au-delà de laquelle les couches en silicium amorphe 12, 13, 14 sont irrémédiablement dégradées.

La mise en œuvre d'un rayonnement 20 dont le rapport de flux de photons est inférieur à 70/30 constitue un excellent compromis entre le flux total de photons $\phi_T$ absorbé par l'empilement 10' et son échauffement.

En effet, l'empilement 10' peut également présenter une température critique comprise entre 218 °C et 250 °C, permettant de réaliser le traitement sans recourir à un système de refroidissement.

Selon un mode de réalisation, le rayonnement électromagnétique 20 est constitué d'une première composante et d'une deuxième composante. La première composante est avantageusement comprise entre 300 nm et 550 nm et la deuxième composante est avantageusement comprise entre 550 nm et 1100 nm. Les première et deuxième composantes correspondent par exemple aux plages A et B illustrées dans la figure 3. Chaque longueur d'onde appartient préférentiellement à l'une des deux composantes. Par exemple, ladite au moins une première longueur d'onde appartient à la première composante. De la même manière, ladite au moins une deuxième longueur d'onde appartient à la deuxième composante.

Afin de contrôler l'échauffement de l'empilement à traiter, comme illustré par les figures 6 et 7, il est avantageux d'exposer ledit empilement à un rayonnement comprenant au moins une composante monochromatique. En d'autres termes, la première et/ou la deuxième composante peut être monochromatique. Par monochromatique, on entend que la composante ne comprend qu'une seul longueur d'onde. À l'inverse, par polychromatique, on entend que la composante comprend une pluralité de longueurs d'onde. De manière plus spécifique, on peut considérer qu'une composante est monochromatique dès lors qu'elle ne comprend qu'une raie présentant une largeur à mi-hauteur inférieure ou égale à 10 nm. De plus, il est préférable que la raie présente :

-    une irradiance spectrale maximum supérieure à 0,04 W/m$^2$/nm ; et

-    une irradiance spectrale minimum inférieure ou égale à 0,04 W/m$^2$/nm.

On peut considérer qu'une composante est polychromatique dès lors qu'elle comprend :

-    une raie présentant une largeur à mi-hauteur supérieure à 10 nm ;

-    une pluralité de raies ; ou

-    une irradiance spectrale supérieure à 0,04 W/m2/nm sur une large étendue spectrale.

De manière particulière, les figures 6 et 7 présentent des résultats de simulation dans lesquels les deux composantes du rayonnement électromagnétique mis en œuvre sont monochromatiques. En effet, la première composante présente une première longueur d'onde unique à 400 nm et la deuxième composante présente une deuxième longueur d'onde unique à 1000 nm.

Ainsi, la première irradiance mesurée entre 300 nm et 550 nm peut être associée à la première composante. De la même manière, la deuxième irradiance mesurée entre 550 nm et 1100 nm peut être associée à la première composante.

D'ailleurs il est avantageux que la deuxième irradiance soit mesurée sur la même étendue que la deuxième composante. Ainsi, lorsque le rayonnement présente une troisième irradiance, alors la deuxième composante peut être comprise entre 800 nm et 1100 nm afin de correspondre exactement à l'étendue sur laquelle est mesurée la deuxième irradiance. Selon cet exemple, le rayonnement électromagnétique est constitué de :

-    la première composante s'étend entre 300 nm et 550 nm ; et

-    la deuxième composante s'étend entre 800 nm et 1100 nm.

En dehors des première et deuxième composantes, le rayonnement électromagnétique est préférentiellement négligeable, c'est à dire qu'il présente par exemple une irradiance spectrale inférieur à 0,04 W/m$^2$/nm.

De la même manière, le premier flux de photons, dont la longueur d'onde est comprise entre 300 nm et 550 nm, peut être associé à la première composante. Le deuxième flux de photons, dont la longueur d'onde est comprise entre 550 nm et 1100 nm, voire 800 nm et 1100 nm, peut être associé à la deuxième composante.

Afin d'augmenter la cinétique de traitement tout en évitant la mise en œuvre d'un système de refroidissement, un mode de réalisation particulier du procédé de traitement prévoit le traitement d'un empilement 10' par un rayonnement 20 comprenant uniquement des photons dont la longueur d'onde est comprise entre 300 nm et 550 nm, par exemple 400 nm, le rayonnement présentant une irradiance totale E élevée, par exemple supérieure ou égale à 200 kW/m$^2$ et la durée de traitement étant inférieure ou égale à 12 s. Ce mode de mise en œuvre permet de profiter de l'efficacité de traitement offert par les courtes longueurs d'onde tout en contrôlant la température de l'empilement 10'. La durée de traitement t peut avantageusement être réduite afin de réduire l'échauffement de l'empilement 10' de sorte que sa température soit maintenue inférieure à 200 °C ou brièvement comprise entre 200 °C et 320 °C. Dans cet exemple, le substrat 11 peut être dopé de type n.

La durée de traitement t peut également être avantageusement réduite afin de réduire l'échauffement de l'empilement 10' de sorte que sa température soit maintenue inférieure à sa température critique ou brièvement comprise entre la température critique et la température maximale.

Par exemple, l'étape d'exposition au rayonnement électromagnétique peut être continue, c'est-à-dire accomplie en une seule fois, si la durée de traitement t et l'irradiance totale $E$ du rayonnement électromagnétique 20 sont telles que la température de l'empilement 10' ne dépasse pas 200 °C (avec éventuellement l'aide du système de refroidissement). Si la durée de traitement t et l'irradiance totale E du rayonnement sont telles que la température de l'empilement dépasse 200 °C (par exemple $\phi_A/\phi_B$ = 100/0), en l'absence de système de refroidissement ou en cas de système de refroidissement insuffisant, l'étape d'exposition peut être réalisée par séquences, c'est-à-dire décomposée en plusieurs phases d'exposition qui sont séparées par des phases de refroidissement (par exemple par convection naturelle ou forcée). La durée de traitement t est alors atteinte en $N$ phases d'exposition de $x$ secondes ($N$ étant un entier naturel positif et $x$ un nombre réel positif). Le choix entre la mise en œuvre continue ou séquentielle de l'étape d'exposition peut également dépendre de la température critique.

Dans un mode de mise en œuvre préférentiel du procédé de traitement, l'irradiance totale $E$ du rayonnement électromagnétique 20 est supérieure ou égale à 1000 kW/m2 et la durée de traitement t est avantageusement inférieure ou égale à 2,5 secondes.

Une durée d'exposition inférieure ou égale à 2,5 s permet de relâcher les contraintes sur la mise en œuvre du procédé, en particulier sur la gestion thermique de l'empilement 10'. Cela peut permettre de réaliser l'étape d'exposition en une seule fois, de réduire le nombre de phases dans le cas d'une étape d'exposition séquentielle ou d'utiliser un système de refroidissement moins performant (et donc moins coûteux).

Par exemple, le silicium amorphe de l'empilement 10' peut supporter une température d'environ 320 °C pendant 0,2 seconde environ (après quoi il subit des dommages irréversibles). Il peut donc être envisagé de réaliser l'étape d'exposition de façon séquentielle, avec des phases de durée égale à 0,2 s, si besoin en maintenant la température de l'empilement en dessous de 320 °C.

Le procédé de traitement décrit ci-dessus peut être accompli à différents stades de la fabrication d'une cellule photovoltaïque à hétérojonction. Une cellule photovoltaïque à hétérojonction désigne une cellule photovoltaïque réalisée à partir d'un substrat en silicium cristallin. Le substrat peut être dopé de type n ou de type p. Cette cellule photovoltaïque peut être une cellule monofaciale ou bifaciale. Dans une cellule monofaciale, seule la face avant capte le rayonnement solaire. Dans une cellule bifaciale, les faces avant et arrière captent chacune une partie du rayonnement solaire. La face avant capte le rayonnement incident (i.e. direct) tandis que la face arrière capte le rayonnement diffus ou réfléchi. La face avant d'une cellule bifaciale est celle permettant d'obtenir le maximum de courant électrique lorsqu'elle est tournée vers le rayonnement incident. L'émetteur de la cellule photovoltaïque à hétérojonction de type n, c'est-dire la couche de silicium amorphe dopé de type p, peut être situé en face avant ou en face arrière de la cellule. Dans ce dernier cas on parle alors de cellule photovoltaïque à hétérojonction à émetteur inversé.

De manière générale, le procédé de fabrication d'une cellule photovoltaïque à hétérojonction comprend (en référence à la figure 1) :

- le dépôt d'une première couche de passivation 14 en silicium amorphe hydrogéné (de préférence intrinsèque) sur une première face du substrat 11 ;

- le dépôt d'une première couche de silicium amorphe dopé 12 de type n (et de préférence hydrogéné) sur la première couche de passivation 14 ;

- le dépôt d'une première couche d'oxyde transparent conducteur 15 sur la première couche de silicium amorphe dopé 12 ; et

- la formation d'au moins une électrode de collecte 16 sur la première couche d'oxyde transparent conducteur 15 ;

- le dépôt d'une deuxième couche de passivation 14 sur une deuxième face opposée du substrat 11 ;

- le dépôt d'une deuxième couche de silicium amorphe 13, dopé de type p (et de préférence hydrogéné) sur la deuxième couche de passivation 14.

La fabrication d'une cellule photovoltaïque bifaciale, telle que la cellule photovoltaïque 10 illustrée par la figure 1, comprend en outre le dépôt d'une deuxième couche d'oxyde transparent conducteur 15 sur la deuxième couche de silicium amorphe dopé 13 et la formation d'au moins une électrode de collecte 16 sur la deuxième couche d'oxyde transparent conducteur 15.

Pour ne pas complexifier le procédé de fabrication de la cellule photovoltaïque en créant une étape supplémentaire, le procédé de traitement est avantageusement intégré à une étape déjà existante. Par exemple, l'empilement comprenant le substrat 11, la première couche de passivation 14 et la première couche en silicium amorphe dopé 12 peut être illuminé lors du dépôt de la première couche d'oxyde transparent conducteur 15. L'empilement peut également être illuminé lors du dépôt de la couche de silicium amorphe dopé n.

L'empilement peut être également être illuminé lors du dépôt de la deuxième couche d'oxyde transparent conducteur 15 sur la deuxième couche de silicium amorphe dopé 13. L'interface entre chaque couche d'oxyde transparent conducteur et la couche de silicium amorphe dopé sous-jacente peut être ainsi améliorée.

L'empilement peut être également illuminé lors de la formation des électrodes de collecte 16 sur la première couche d'oxyde transparent conducteur 15 ou, dans le cas d'une cellule bifaciale uniquement, sur la deuxième couche d'oxyde transparent conducteur 15. La formation des électrodes de collecte 16 comprend généralement deux opérations :

- une première opération consistant à déposer par sérigraphie une pâte métallique sur la (première et/ou deuxième) couche d'oxyde transparent conducteur 15 ; et

- une deuxième opération consistant à durcir la pâte métallique, par exemple au moyen d'un traitement thermique, afin de diminuer la résistivité des électrodes de collecte (métalliques).

Cette deuxième opération de durcissement de la pâte métallique et l'étape d'exposition de l'empilement sont avantageusement accomplies simultanément. La chaleur produite par l'illumination contribue ainsi au durcissement de la pâte métallique.

Le procédé de traitement peut être également appliqué à une cellule photovoltaïque à hétérojonction dans son état final (après la formation des électrodes de collecte 16 sur la ou les couches d'oxyde transparent conducteur 15).

Dans le cadre de la fabrication de cellule photovoltaïque dite "à contact arrière interdigité" ou "interdigitated back contact" (IBC) en anglais, la cellule IBC comprend une première et une deuxième couche de passivation déposée respectivement sur la première face et la deuxième face d'un substrat. Une couche de traitement anti-reflet peut être déposée sur la deuxième couche de passivation. La deuxième face du substrat constitue la face avant de la cellule IBC et est destinée à recevoir le rayonnement solaire. Une alternance de couches en silicium amorphe dopé de type p et de type n sont déposées les unes à côtés des autres sur la première couche de passivation, soit sur la face arrière de la cellule IBC. Une pluralité de couches en oxyde transparent conducteur peuvent être déposées, chacune sur une des couches en silicium amorphe dopé. Des métallisations peuvent également être déposées sur chaque couche en oxyde transparent conducteur afin de pouvoir connecter électriquement la cellule IBC. Il peut être avantageux de traiter la cellule IBC avant le dépôt des couches d'oxyde transparent conducteur. La première face du substrat, soit la face arrière de la cellule IBC, est tournée vers la source de rayonnement. Exposer les couches d'oxyde transparent conducteur avant le dépôt des métallisations permet d'améliorer la qualité de desdites couches et ainsi réduire la résistance série de la cellule IBC. Exposer les couches d'oxyde transparent conducteur après le dépôt des métallisations permet d'améliorer l'interface entre lesdites couches et les métallisation, réduisant davantage la résistance série de la cellule IBC.

Dans le cadre de la fabrication de cellules dites « tandem » comprenant une première cellule à base de pérovskite (cellule dite « supérieure ») disposée sur une cellule à hétérojonction de silicium (cellule dite « inférieure »), il peut être également avantageux de traiter la cellule à hétérojonction avant le dépôt de la cellule pérovskite, à la fois pour améliorer les couches de passivation de la cellule à hétérojonction et pour améliorer la future interface entre les deux cellules. Dans ce cas, le procédé de traitement peut intervenir en fin de fabrication de la cellule à hétérojonction ou lors d'une des étapes de fabrication de la cellule à hétérojonction.

Alternativement, le procédé de traitement peut être appliqué après le dépôt de la cellule pérovskite sur la cellule à hétérojonction de silicium, à la condition de maintenir une température de traitement inférieure à 200 °C, de préférence sensiblement égale à 100 °C.

Enfin, le procédé de traitement peut être appliqué également un module photovoltaïque pour peu que la température du procédé de traitement soit compatible avec les éléments constitutifs du module. Le module photovoltaïque comprend au moins deux cellules photovoltaïque à hétérojonction de silicium (SHJ) connectées électriquement entre elles, soit directement, soit au sein d'une chaîne photovoltaïque comprenant au moins une autre cellule SHJ. Les cellules SHJ sont par exemple du même type de la figure 1 et comprennent en outre :

- un substrat en silicium cristallin ;

- une première couche de passivation en silicium amorphe hydrogéné, disposée sur une première face du substrat ; et

- une première couche en silicium amorphe, dopé de type n, disposée sur la première couche de passivation.

Le procédé de traitement d'un module comprend une étape d'exposition de chaque empilement des cellules SHJ à un rayonnement électromagnétique. Chaque première face du substrat est tournée vers une source de rayonnement électromagnétique. Il peut s'agir d'une source ponctuelle, linéique ou étendue, fixe ou balayant la surface du module. Toutes les cellules SHJ peuvent par exemple présenter leurs premières faces sur une des faces du module photovoltaïque, auquel cas une seule réalisation de l'étape d'exposition est nécessaire. En revanche, et notamment dans le cas de cellules bifaciales, les cellules SHJ peuvent être alternées au sein du module, présentant successivement la première face du substrat ou la deuxième face du substrat. Dans ce cas-là, le procédé de traitement répète avantageusement l'étape d'exposition sur chaque face du module photovoltaïque afin d'exposer chaque première face du substrat.

L'étape d'exposition mis en œuvre dans le procédé de fabrication d'une cellule ou de traitement d'un module est avantageusement identique à l'étape d'exposition du procédé de traitement d'un empilement. Le rayonnement électromagnétique mis en œuvre à chaque étape d'exposition du procédé de traitement d'un module est avantageusement le même que celui mis en œuvre dans le procédé de traitement d'un empilement. Ainsi, tous les modes de mise en œuvre et toutes les caractéristiques du procédé de traitement d'un empilement décrit précédemment sont applicables au procédé de traitement du module.

## Revendications

1. Procédé de traitement d'un empilement (10'), l'empilement comprenant :

   - un substrat (11) en silicium cristallin ;
   - une première couche de passivation (14) en silicium amorphe hydrogéné, disposée sur une première face (11a) du substrat (11) ; et
   - une première couche en silicium amorphe dopé de type n (12), disposée sur la première couche de passivation (14) ;

   le procédé comprenant une étape d'exposition de l'empilement (10') à un rayonnement électromagnétique (20) émis par une source de rayonnement électromagnétique (40), la première face (11a) du substrat (11) étant tournée vers la source de rayonnement électromagnétique (40), le rayonnement électromagnétique (20) présentant au moins une première longueur d'onde comprise entre 300 nm et 550 nm et au moins une deuxième longueur d'onde comprise entre 800 nm et 1100 nm et le rayonnement électromagnétique présentant une irradiance spectrale entre 550 nm et 800 nm inférieure ou égale à 0,04 W/m$^2$/nm.

2. Procédé selon l'une des revendications précédentes, dans lequel le rayonnement électromagnétique est constitué d'une première composante et d'une deuxième composante, la première composante étant comprise entre 300 nm et 550 nm et la deuxième composante étant comprise entre 550 nm et 1100 nm, au moins l'une des première et deuxième composantes étant monochromatique.

3. Procédé selon l'une quelconque des revendications précédentes, dans lequel le rayonnement électromagnétique (20) présente :

   - une première irradiance ($E_A$) mesurée sur la plage de longueurs d'onde comprise entre 300 nm et 550 nm ;
   - une deuxième irradiance ($E_B$) mesurée sur la plage de longueurs d'onde comprise entre 550 nm et 1100 nm ; et
   - une irradiance totale ($E$) mesurée sur la plage de longueurs d'onde comprise entre 300 nm et 1100 nm ;

   la première irradiance étant supérieure à 10 % de l'irradiance totale.

4. Procédé selon l'une quelconque des revendications précédentes, dans lequel la première irradiance ($E_A$) est mesurée sur la plage de longueurs d'onde comprise entre 400 nm et 550 nm.

5. Procédé selon l'une quelconque des revendications précédentes, dans lequel le rayonnement électromagnétique comprend un premier flux ($\phi_A$) de photons dont la longueur d'onde est comprise entre 300 nm et 550 nm et un deuxième flux ($\phi_B$) de photons dont la longueur d'onde est comprise entre 550 nm et 1100 nm, le rapport du premier flux de photons par le deuxième flux de photon ($\phi_A/\phi_B$) étant inférieur ou égal à 70/30.

6. Procédé selon la revendication précédente, dans lequel le rayonnement électromagnétique comprend un flux total de photons égal à la somme du premier flux de photons ($\phi_A$) et du deuxième flux de photons ($\phi_B$), le flux total de photons étant supérieur ou égal à 8,95161 $\times$ 10$^{21}$ photon/m$^2$/s.

**7.** Procédé selon l'une quelconque des revendications précédentes, dans lequel la température de l'empilement (10') est inférieure à 320 °C lors de l'étape d'exposition au rayonnement électromagnétique (20).

**8.** Procédé selon l'une quelconque des revendications précédentes, dans lequel l'étape d'exposition est continue.

**9.** Procédé selon l'une quelconque des revendications 1 à 8, dans lequel l'étape d'exposition est réalisée par séquences.

**10.** Procédé selon l'une quelconque des revendications précédentes, dans lequel l'empilement (10') comprend en outre une couche d'oxyde transparent conducteur (15) disposée sur la première couche en silicium amorphe dopé (12).

**11.** Procédé selon l'une quelconque des revendications précédentes, dans lequel l'empilement (10') comprend :

- une deuxième couche de passivation (14) en silicium amorphe hydrogéné, disposée sur une deuxième face (11b) du substrat (11), la deuxième face du substrat (11b) étant opposée à la première face du substrat (11a) ; et
- une deuxième couche en silicium amorphe dopé de type p (13), disposée sur la deuxième couche de passivation (14).

**12.** Procédé selon l'une quelconque des revendications 1 à 11, dans lequel l'empilement (10') comprend en outre une deuxième couche en silicium amorphe dopé de type p (13), la deuxième couche en silicium amorphe dopé (13) étant également disposée sur la première couche de passivation (14).

**13.** Procédé de fabrication d'une cellule à hétérojonction de silicium, comprenant les étapes suivantes :

- former un empilement en déposant une première couche de passivation en silicium amorphe (14) hydrogéné sur une première face (11a) d'un substrat en silicium cristallin (11) et une première couche en silicium amorphe dopé de type n (12) sur la première couche de passivation (14); et
- exposer l'empilement à un rayonnement électromagnétique (20) émis par la source de rayonnement électromagnétique (40), la première face du substrat (11a) étant tournée vers la source de rayonnement électromagnétique (20), le rayonnement électromagnétique (20) présentant au moins une première longueur d'onde comprise entre 300 nm et 550 nm et au moins une deuxième longueur d'onde comprise entre 800 nm et 1100 nm et le rayonnement électromagnétique présentant une irradiance spectrale entre 550 nm et 800 nm inférieure ou égale à 0,04 W/m$^2$/nm.

**14.** Procédé de traitement d'un module photovoltaïque, le module photovoltaïque comprenant au moins deux cellules photovoltaïques à hétérojonction de silicium connectés électriquement, chaque cellule photovoltaïque à hétérojonction de silicium comprenant un empilement, l'empilement comprenant :

- un substrat en silicium cristallin ;
- une première couche de passivation en silicium amorphe hydrogéné, disposée sur une première face du substrat ; et
- une première couche en silicium amorphe dopé de type n, disposée sur la première couche de passivation ;

le procédé de traitement du module photovoltaïque comprenant une étape d'exposition de chaque empilement à un rayonnement électromagnétique émis par une source de rayonnement électromagnétique, chaque première face du substrat étant tournée vers la source de rayonnement électromagnétique, le rayonnement électromagnétique présentant au moins une première longueur d'onde comprise entre 300 nm et 550 nm et au moins une deuxième longueur d'onde comprise entre 800 nm et 1100 nm et le rayonnement électromagnétique présentant une irradiance spectrale entre 550 nm et 800 nm inférieure ou égale à 0,04 W/m$^2$/nm.

**Patentansprüche**

**1.** Verfahren zur Behandlung eines Stapels (10'), wobei der Stapel umfasst:

- ein Substrat (11) aus kristallinem Silizium;
- eine erste Passivierungsschicht (14) aus hydriertem amorphem Silizium, die auf einer ersten Seite (11a) des Substrats (11) angeordnet ist; und

- eine erste Schicht aus n-dotiertem amorphem Silizium (12), die auf der ersten Passivierungsschicht (14) angeordnet ist;

wobei das Verfahren einen Schritt umfasst, bei dem der Stapel (10') elektromagnetischer Strahlung (20) ausgesetzt wird, die von einer elektromagnetischen Strahlungsquelle (40) emittiert wird, wobei die erste Seite (11a) des Substrats (11) der elektromagnetischen Strahlungsquelle (40) zugewandt ist, wobei die elektromagnetische Strahlung (20) mindestens eine erste Wellenlänge zwischen 300 nm und 550 nm und mindestens eine zweite Wellenlänge zwischen 800 nm und 1100 nm aufweist und die elektromagnetische Strahlung eine spektrale Strahlungsstromstärke zwischen 550 nm und 800 nm von höchstens 0,04 W/m$^2$/nm aufweist.

2. Verfahren nach einem der vorstehenden Ansprüche, bei dem die elektromagnetische Strahlung aus einer ersten Komponente und einer zweiten Komponente besteht, wobei die erste Komponente im Bereich zwischen 300 nm und 550 nm und die zweite Komponente im Bereich zwischen 550 nm und 1100 nm liegt, wobei mindestens eine der ersten und zweiten Komponenten monochromatisch ist.

3. Verfahren nach einem der vorstehenden Ansprüche, bei dem die elektromagnetische Strahlung (20) Folgendes aufweist:

- eine erste Strahlungsstromstärke ($E_A$), gemessen im Wellenlängenbereich zwischen 300 nm und 550 nm;
- eine zweite Strahlungsstromstärke ($E_B$), gemessen im Wellenlängenbereich zwischen 550 nm und 1100 nm; und
- eine Gesamtstrahlungsstromstärke ($E$), gemessen im Wellenlängenbereich zwischen 300 nm und 1100 nm;

wobei die erste Strahlungsstromstärke mehr als 10 % der Gesamtstrahlungsstromstärke beträgt.

4. Verfahren nach einem der vorstehenden Ansprüche, bei dem die erste Strahlungsstromstärke ($E_A$) im Wellenlängenbereich zwischen 400 nm und 550 nm gemessen wird.

5. Verfahren nach einem der vorstehenden Ansprüche, bei dem die elektromagnetische Strahlung einen ersten Fluss ($\Phi_{(A)}$) von Photonen, deren Wellenlänge zwischen 300 nm und 550 nm liegt, und einen zweiten Fluss ($\Phi_B$) von Photonen, deren Wellenlänge zwischen 550 nm und 1100 nm liegt, umfasst, wobei das Verhältnis des ersten Photonenflusses zum zweiten Photonenfluss ($\Phi_{(A)}/\Phi_B$) kleiner oder gleich 70/30 ist.

6. Verfahren nach dem vorstehenden Anspruch, bei dem die elektromagnetische Strahlung einen Gesamtphotonenfluss umfasst, der der Summe des ersten Photonenflusses ($\Phi_A$) und des zweiten Photonenflusses ($\Phi_B$) entspricht, wobei der Gesamtphotonenfluss größer oder gleich $8,95161 \times 10^{21}$ Photon/m$^2$/s ist.

7. Verfahren nach einem der vorstehenden Ansprüche, bei dem die Temperatur des Stapels (10') während des Schritts der Bestrahlung mit elektromagnetischer Strahlung (20) unter 320 °C liegt.

8. Verfahren nach einem der vorstehenden Ansprüche, bei dem der Bestrahlungsschritt kontinuierlich erfolgt.

9. Verfahren nach einem der Ansprüche 1 bis 8, bei dem der Bestrahlungsschritt sequenziell durchgeführt wird.

10. Verfahren nach einem der vorstehenden Ansprüche, bei dem der Stapel (10') ferner eine auf der ersten Schicht aus dotiertem amorphem Silizium (12) angeordnete Schicht aus transparentem, leitfähigem Oxid (15) umfasst.

11. Verfahren nach einem der vorstehenden Ansprüche, bei dem der Stapel (10') umfasst:

- eine zweite Passivierungsschicht (14) aus hydriertem amorphem Silizium, die auf einer zweiten Seite (11b) des Substrats (11) angeordnet ist, wobei die zweite Seite des Substrats (11b) der ersten Seite des Substrats (11a) gegenüberliegt; und
- eine zweite Schicht aus p-dotiertem amorphem Silizium (13), die auf der zweiten Passivierungsschicht (14) angeordnet ist.

12. Verfahren nach einem der Ansprüche 1 bis 11, bei dem der Stapel (10') ferner eine zweite Schicht aus p-dotiertem amorphem Silizium (13) umfasst, wobei die zweite Schicht aus dotiertem amorphem Silizium (13) ebenfalls auf der ersten Passivierungsschicht (14) angeordnet ist.

13. Verfahren zur Herstellung einer Silizium-Heteroübergangssolarzelle, das folgende Schritte umfasst:

- Bilden eines Stapels durch Aufbringen einer ersten Passivierungsschicht aus hydriertem amorphem Silizium (14) auf eine erste Seite (11a) eines kristallinen Siliziumsubstrats (11) und einer ersten Schicht aus n-dotiertem amorphem Silizium (12) auf die erste Passivierungsschicht (14); und
- Aussetzen des Stapels einer elektromagnetischen Strahlung (20), die von der elektromagnetischen Strahlungsquelle (40) emittiert wird, wobei die erste Seite des Substrats (11a) der elektromagnetischen Strahlungsquelle (20) zugewandt ist, wobei die elektromagnetische Strahlung (20) mindestens eine erste Wellenlänge zwischen 300 nm und 550 nm und mindestens eine zweite Wellenlänge zwischen 800 nm und 1100 nm aufweist und die elektromagnetische Strahlung eine spektrale Strahlungsstromstärke zwischen 550 nm und 800 nm von höchstens 0,04 W/m$^2$ /nm aufweist.

14. Verfahren zur Behandlung eines Photovoltaikmoduls, wobei das Photovoltaikmodul mindestens zwei elektrisch miteinander verbundene Silizium-Heteroübergangssolarzellen umfasst, wobei jede Silizium-Heteroübergangssolarzelle einen Stapel umfasst, der wiederum Folgendes umfasst:

- ein Substrat aus kristallinem Silizium;
- eine erste Passivierungsschicht aus hydriertem amorphem Silizium, die auf einer ersten Seite des Substrats angeordnet ist; und
- eine erste Schicht aus n-dotiertem amorphem Silizium, die auf der ersten Passivierungsschicht angeordnet ist;

wobei das Verfahren zur Behandlung des Photovoltaikmoduls einen Schritt umfasst, bei dem jeder Stapel elektromagnetischer Strahlung ausgesetzt wird, die von einer elektromagnetischen Strahlungsquelle emittiert wird, wobei jede erste Seite des Substrats der elektromagnetischen Strahlungsquelle zugewandt ist, wobei die elektromagnetische Strahlung mindestens eine erste Wellenlänge zwischen 300 nm und 550 nm und mindestens eine zweite Wellenlänge zwischen 800 nm und 1100 nm aufweist und die elektromagnetische Strahlung eine spektrale Strahlungsstromstärke zwischen 550 nm und 800 nm von höchstens 0,04 W/m$^2$/nm aufweist.

## Claims

1. A method for treating a stack (10'), the stack comprising:

- a substrate (11) of crystalline silicon;
- a first passivation layer (14) of hydrogenated amorphous silicon, disposed on a first face (11a) of the substrate (11); and
- a first layer (12) of n-doped amorphous silicon, disposed on the first passivation layer (14);

the method comprising a step of exposing the stack (10') to electromagnetic radiation (20) emitted by an electromagnetic radiation source (40), the first face (11a) of the substrate (11) pointing to the electromagnetic radiation source (40), the electromagnetic radiation (20) having at least one first wavelength between 300 nm and 550 nm and at least one second wavelength comprised between 800 nm and 1100 nm and the electromagnetic radiation has a spectral irradiance between 550 nm and 800 nm less than or equal to 0.04 W/m$^2$/nm.

2. The method according to any of the preceding claims, wherein the electromagnetic radiation consists of a first component and a second component, the first component being comprised between 300 nm and 550 nm, and the second component being comprised between 550 nm and 1100 nm, at least one of the first and second components being monochromatic.

3. The method according to any of the preceding claims, wherein the electromagnetic radiation (20) has:

- a first irradiance ($E_A$) measured over the wavelength range between 300 nm and 550 nm;
- a second irradiance ($E_B$) measured over the wavelength range between 550 nm and 1100 nm; and
- a total irradiance ($E$) measured over the wavelength range between 300 nm and 1100 nm;

the first irradiance being greater than 10% of the total irradiance.

4. The method according to any of the preceding claims, wherein the first irradiance ($E_A$) is measured over the wavelength range comprised between 400 nm and 550 nm.

5. The method according to any of the preceding claims, wherein the electromagnetic radiation comprises a first photon flux ($\phi_A$) having a wavelength comprised between 300 nm and 550 nm and a second photon flux ($\phi_B$) having a wavelength comprised between 550 nm and 1100 nm, the ratio of the first photon flux to the second photon flux ($\phi_A/\phi_B$) being less than or equal to 70/30.

6. The method according to any of the preceding claims, wherein the electromagnetic radiation comprises a total photon flux equal to the sum of the first photon flux ($\phi_A$) and the second photon flux ($\phi_B$), the total photon flux being greater than or equal to $8.95161 \times 10^{21}$ photon/m$^2$/s.

7. The method according to any one of the preceding claims, wherein the temperature of the stack (10') is less than 320°C during the step of exposing to electromagnetic radiation (20).

8. The method according to any of the preceding claims, wherein the exposure step is continuous.

9. The method according to any one of claims 1 to 8, wherein the exposure step is performed in sequences.

10. The method according to any one of the preceding claims, wherein the stack (10') further comprises a conductive transparent oxide layer (15) disposed on the first layer (12) of doped amorphous silicon.

11. The method according to any of the preceding claims, wherein the stack (10') comprises:

   - a second passivation layer (14) of hydrogenated amorphous silicon, disposed on a second face (11b) of the substrate (11), the second face of the substrate (11b) being opposite to the first face of the substrate (11a); and
   - a second layer (13) of p-doped amorphous silicon, disposed on the second passivation layer (14).

12. The method according to any one of claims 1 to 11, wherein the stack (10') further comprises a second layer (13) of p-type doped amorphous silicon, the second layer (13) of doped amorphous silicon being also disposed on the first passivation layer (14).

13. A method for manufacturing a silicon heterojunction cell, comprising the following steps of:

   - forming a stack by depositing a first hydrogenated amorphous silicon passivation layer (14) onto a first face (11a) of a crystalline silicon substrate (11) and a first layer (12) of n-doped amorphous silicon onto the first passivation layer (14); and
   - exposing the stack to electromagnetic radiation (20) emitted by the electromagnetic radiation source (40), the first face of the substrate (11a) pointing to the electromagnetic radiation source (20), the electromagnetic radiation (20) having at least one first wavelength comprised between 300 nm and 550 nm and at least one second wavelength comprised between 800 nm and 1100 nm and the electromagnetic radiation has a spectral irradiance comprised between 550 nm and 800 nm less than or equal to 0.04 W/m$^2$/nm.

14. A method for treating a photovoltaic module, the photovoltaic module comprising at least two electrically connected silicon heterojunction photovoltaic cells, each silicon heterojunction photovoltaic cell comprising a stack, the stack comprising:

   - a crystalline silicon substrate;
   - a first passivation layer of hydrogenated amorphous silicon, disposed on a first face of the substrate; and
   - a first layer of n-type doped amorphous silicon, disposed on the first passivation layer;

   the method for treating the photovoltaic module comprising a step of exposing each stack to electromagnetic radiation emitted by an electromagnetic radiation source, each first face of the substrate pointing to the electromagnetic radiation source, the electromagnetic radiation having at least one first wavelength between 300 nm and 550 nm and at least one second wavelength between 800 nm and 1100 nm and the electromagnetic radiation has a spectral irradiance comprised between 550 nm and 800 nm less than or equal to 0.04 W/m$^2$/nm.

[Fig. 1]

[Fig. 2]

[Fig. 3]

[Fig. 4]

[Fig. 5]

[Fig. 6]

[Fig. 7]

## RÉFÉRENCES CITÉES DANS LA DESCRIPTION

**Documents brevets cités dans la description**

- WO 2013001440 A
- EP 1734589 A2
- EP 3182465 A1

**Littérature non-brevet citée dans la description**

- **E. KOBAYASHI**. *Solar Energy Materials and Solar Cells*, 2017, vol. 173, 43-49